# EUROPEAN PATENT SPECIFICATION

(11) **EP 0 715 074 B1**
(45) Date of publication and mention of the grant of the patent: **13.10.1999**
(21) Application number: 95120720.8
(22) Date of filing: 30.11.1992
(51) Int. Cl.: F02P 17/00, G01R 15/06, G01R 31/00

(54) **A spark plug voltage probe device for an internal combustion engine**
Spannungstester für Zündkerzen in einer Brennkraftmaschine
Testeur de potentiel de bougie d'allumage dans un moteur à combustion interne

(30) Priority: 28.11.1991 JP 31478391; 29.11.1991 JP 31668591; 11.05.1992 JP 11768392; 13.11.1992 JP 30385992
(43) Date of publication of application: 05.06.1996
(62) Divisional of application: 92310909.4
(73) Proprietor: NGK SPARK PLUG CO., LTD, Nagoya-shi (JP)
(72) Inventor: Miyata, Shigeru, c/o NGIC Spark Plug Co. Ltd., Nagoya-shi (JP); Yoshida, Hideji, c/o NGIC Spark Plug Co. Ltd., Nagoya-shi (JP); Yamada, Yoshitaka, c/o NGIC Spark Plug Co. Ltd., Nagoya-shi (JP); Ito, Yasuo, c/o NGIC Spark Plug Co. Ltd., Nagoya-shi (JP); Matsubara, Yoshihiro, c/o NGIC Spark Plug Co. Ltd., Nagoya-shi (JP)
(74) Representative: Senior, Alan Murray

(56) References cited:
- EP-A- 0 032 647
- GB-A- 2 116 329
- US-A- 4 090 130
- US-A- 5 001 431

## Description

This invention relates to a probe for the detection of voltages applied to spark plugs to detect faulty firing in an internal combustion engine.

With the demand of purifying emission gas and enhancing fuel efficiency of internal combustion engines, it has been necessary to detect the firing condition in each cylinder of the internal combustion engine so as to protect the internal combustion engine plug against misfire. In order to detect the firing condition in each of the cylinders it is known to install an optical sensor within the cylinders. Alternatively, it is also known to attach a piezoelectrical sensor to a seat pad of each spark plug.

Using the prior art, it is troublesome and time-consuming to install a sensor for each of the cylinders, thus increasing the installation cost, and at the same time, taking up a lot time to check and in maintenance.

Document GB-A-2,116,329, upon which the preamble of claim 1 is based, describes a system for recognising misfirings on the basis of voltage change signals in a capacitance formed between spark plug cables in grooves and a correspondingly corrugated electrode plate.

It is one of the objects of the invention to provide a spark plug voltage probe device for an internal combustion engine which is capable of detecting a voltage applied to the spark plug of each cylinder of the internal combustion engine precisely with a relatively simple structure.

According to the present invention, there is provided a sparkplug voltage probe device for attachment to an internal combustion engine and for detecting a voltage applied to spark plugs installed in the internal combustion engine by way of corresponding cables, the device comprising:
an insulator base;
a plurality of grooves in which the corresponding cables are to be placed; and
an electrode layer embedded in the insulator base alone the grooves for forming a static capacitance between the electrode layer and placed cables when the voltage is supplied across the spark plugs; characterised by further comprising
an electrical shield casing in which at least one electrical circuit board is accommodated, the shield casing having an electrically conductive wall electrically grounded in use;
a lead wire connecting the electrode layer to said at least one electrical circuit board
a rubber plate securely attached to a lower surface of the insulator base; and
an electrical shield sheet fixedly attached to lower surface of the rubber plate; and in that
the insulator base is securely attached to the outer surface of the base of the electrical shield casing, and the electrode layer is electrically connected to the at least one electrical circuit board so as to analyse a burning condition in the internal combustion engine on the basis of the voltage applied to each of the spark plugs; and
the plurality of grooves is provided between the insulator base and he rubber plate, in use the noise level being reduced by the ratio of the static capacitance C1 which is formed between the electrode layer and the cables to a static capacitance C2 which is formed between the electrically conductive wall and the electrode layer.

The static capacitance formed between the insulator base and spark plug cables is preferably substantially uniform and is sufficient to detect a spark plug voltage in each of the cylinders in the combustion engine using the single spark plug voltage probe device.

The electrical shield sheet makes it is possible to prevent a static capacitance from occurring between the electrode layer and the periphery of the engine when the device is mounted on an engine, thus avoiding sensitivity variation of the spark plug voltage probe device depending on where the probe device is mounted.

According further to the invention, a substantially uniform static capacitance may be formed between each of spark plug cables and corresponding grooves of the electrode layer, so that a substantially constant level of spark plug voltage is obtained in each cylinder of the internal combustion engine, thus making it possible to detect a burning condition in the internal combustion engine precisely.

According to the invention, a second static capacitance (C2) is formed between the electrode layer and conductor wall, the second static capacitance (C2) being greater than the static capacitance (C1) formed between the electrode layer and spark plug cables. The noise level (N), which otherwise would disturb the electrode plate, is reduced by the ratio of (C1/C2) so as to suppress interference in detecting a signal (S) which is outputted from the sparkplug voltage probe device. With electrical circuit boards accommodated into the electrical shield casing and the electrode layer covered by the electrical shield sheet, it is possible to prevent electromagnetical noise from interfering with the electrode layer and electrical circuits when the noise appears due to a high voltage in an ignition system. This makes it possible to reduce the ratio of S/N so as to detect a voltage applied to a spark plug precisely. With the use of the rubber plate, it is possible to prevent the transition of vibrations from the engine to the at least one circuit board. With an integral lamination of the shield casing, the insulator base, the rubber plate and the shield sheet, it is readily possible to mount the probe device on an internal combustion engine.

The present invention may be further understood from the following description, meant by way of example only, with reference to the accompanying drawings, in which:
Fig. 1 is a perspective exploded view of a first spark plug voltage probe device useful for explaining the present invention;
Fig. 2 is a perspective view of the spark plug voltage probe device of Fig. 1;
Fig. 3 is a perspective view with the spark plug voltage probe device of Fig. 1 mounted on an internal combustion engine;
Fig. 4 is a schematic view of an ignition system incorporated into an internal combustion engine;
Fig. 5 is a view similar to Fig. 1 according to a second non-embodiment of the invention;
Fig. 6 is a view similar to Fig. 1 according to a third non-embodiment of the invention;
Fig. 7 is view similar to Fig. 1 according to a fourth non-embodiment of the invention;
Fig. 8 is a perspective view of a spark plug voltage probe device when an upper half and a lower half are in a folded position, according to a fifth non-embodiment of the invention;
Fig. 9 is a perspective view of the spark plug voltage probe device of Fig. 8, with the upper half and lower half in an open position;
Fig. 10 is a perspective view exploded view of a spark plug voltage probe device according to a first embodiment of the invention;
Fig. 11 is a perspective view of the spark plug voltage probe device of Fig. 10; and
Fig. 12 is a perspective view with the spark plug voltage probe device of Fig. 10 mounted on an internal combustion engine.

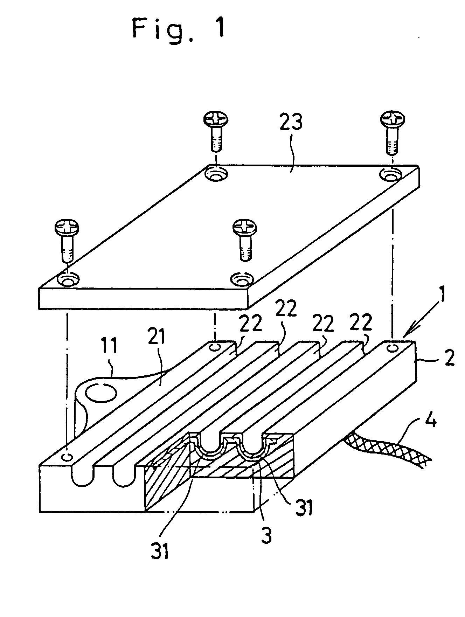

Referring to Fig. 1, this shows a spark plug voltage probe device 1 in an internal combustion engine. This is not in accordance with the present invention but is useful for understanding it. An insulator base 2 has a rectangular upper surface 21 on which a plurality of grooves 22 are provided at regular intervals in a longitudinal direction. Each of the grooves 22 is U-shaped in section. Each diameter of the grooves 22 corresponds to that of spark plug cables (HC), and the number of the grooves 22 corresponds to that of cylinders of the internal combustion engine. Along the grooves 22, an electrode plate 3 is embedded in the insulator base 2. The electrode plate 3 is in the form of a corrugated configuration which has channels 31 corresponding to the grooves 22 of the insulator base 2. The electrode plate 3 is embedded in the insulator base 2 at the time when the insulator base 2 is formed by means of an injection mould, and electrode plate 3 is electrically connected to a microcomputer as described hereinafter. An anchor block 11 is moulded at a side wall of the insulator base 2.

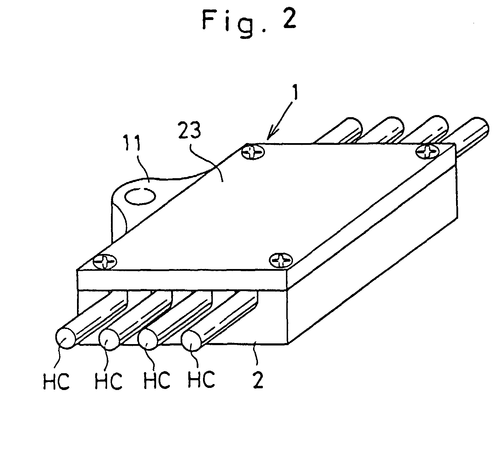

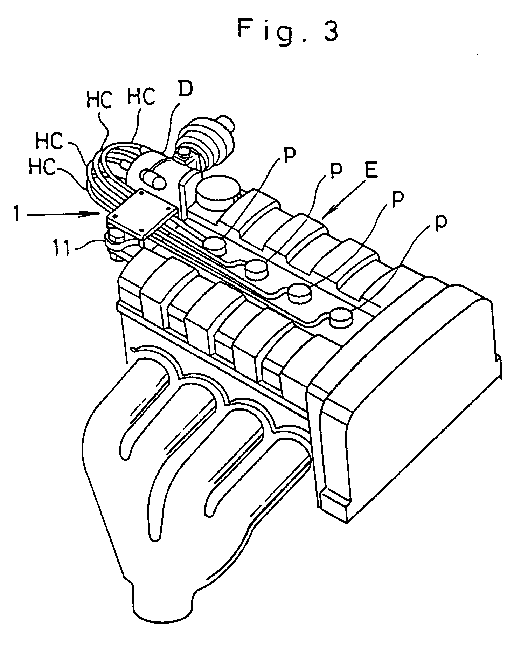

In each of the grooves 22, a cable (HC) is located to form a static capacitance (e.g. 1 pF) between the electrode plate 3 and the cables (HC) as shown in Figure 2. On the upper surface 21 of the insulator base 2, a lid 23 is placed to secure each of the cables (HC) against removal. Then the spark plug voltage probe device 1 is mounted on an internal combustion engine (E) by securing the anchor block 11 to a cylinder head of the internal combustion engine (E), and collects the cables (HC) to introduce them to a distributor (D) as shown in Fig. 3.

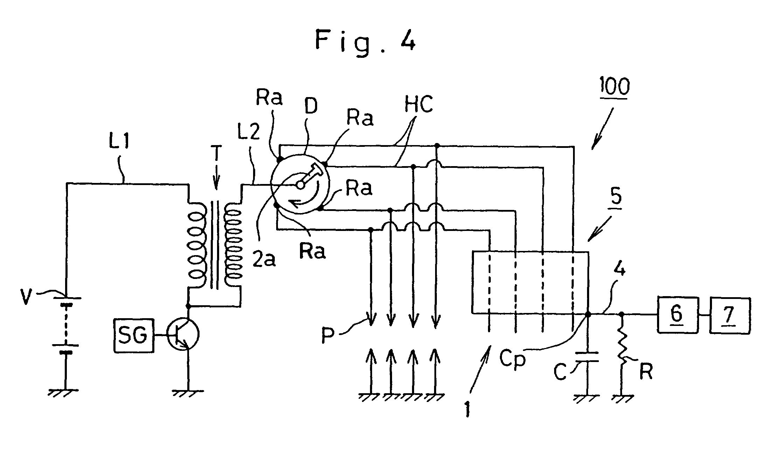

Fig. 4 shows an ignition system 100 which is incorporated into the internal combustion engine (E). The ignition system has an ignition coil (T) having a primary coil (L1) and a secondary coil (L2). In series with the primary coil (L1), a vehicular battery cell (V) and a signal generator (SG) are connected. Each of the cables (HC) has one end electrically connected to the secondary coil (L2) through a rotor 2a of the distributor (D) which integrally incorporates a contact breaker (not shown) and has e.g. four stationary segments (Ra). To each of the stationary segments (Ra), a free end of the rotor 2a approaches to make a series gap with the corresponding segments (Ra) during the rotary movement of the rotor 2a. To each of the four stationary segments (Ra), a spark plug (P) is electrically connected by way of the corresponding cables (HC). Each of the spark plugs (P) is electrically connected to ground so that the secondary coil (L2) energizes each of the spark plugs (P) by way of the cables (HC), the rotor 2a and the stationary segment (Ra) of the distributor (D).

A common point (Cp) between the electrode plate 3 and a lead wire 4, is grounded by way of a capacitor C (3000 pF) to form a voltage divider circuit 5. In parallel with the capacitor (C), an electrical resistor R (e.g. 3 MΩ) is connected to form a discharge circuit for the capacitor (C). The voltage divider circuit 5 divides a spark plug voltage by the order of 3000. The RC time constant is 9 milliseconds, thus making it possible to observe a relatively slow change in the spark plug voltage.

Meanwhile, the lead wire 4 is connected to a spark plug voltage waveform detector circuit 6. The circuit 6 is connected to a distinction circuit (microcomputer) 7 which analyses a burning condition in the internal combustion engine (E) on the basis of the waveform outputted from the circuit 6 as described hereinafter.

The spark plug voltage waveform detector circuit 6 analyses a divided voltage waveform generated from the voltage divider circuit 5, and compares the characteristics of the divided voltage waveform with data determined by experiment.

The divided voltage waveform is analogous to that of the spark plug voltage, and changes depending upon the case in which an air-fuel mixture is normally ignited, and the case in which the air-fuel mixture is not ignited although a spark is established by the spark plug (P). The divided voltage waveform also changes depending upon the smoking of the spark plug (P), deterioration of the ignition coil (T) and a shortage of the vehicular battery cell (V).

Analysis of the divided voltage waveform makes it possible to distinguish normal ignition from accidental misfire and misspark.

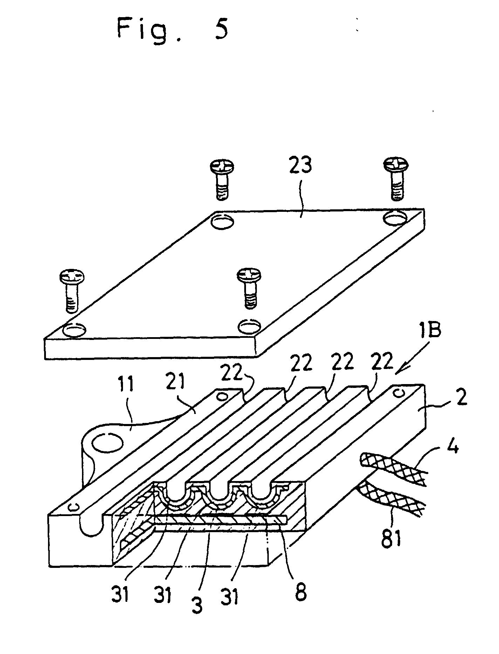

Fig. 5 shows a second non-embodiment of the invention in which a spark plug voltage probe device 1B has an electrical shield sheet 8 embedded in the insulator base 2 of the first non-embodiment, located under the electrode plate 3. The electrical shield sheet 8 is connected to the internal combustion engine (E) by way of a ground wire 81.

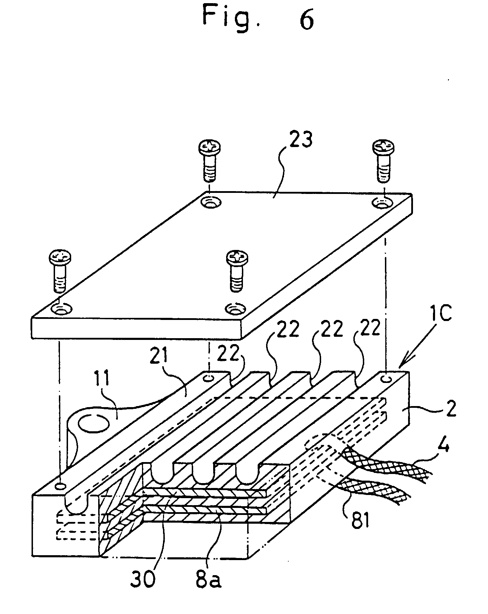

Fig. 6 shows a third non-embodiment of the invention in which a spark plug voltage probe device 1C has an electrical shield sheet 8a embedded in the insulator base 2, located under the electrode plate 30. The electrical shield sheet 8 is connected to the internal combustion engine (E) by way of the ground wire 81. It is observed that the electrical shield sheet may be in the form of meshes or a layer.

With the use of the electrical shield sheet, it is possible to prevent capacitive variation between the electrode plate and the cables when some metallic conductor is present at the periphery of the spark plug voltage probe device. This enables precise detection of the voltage waveform from the voltage divider circuit.

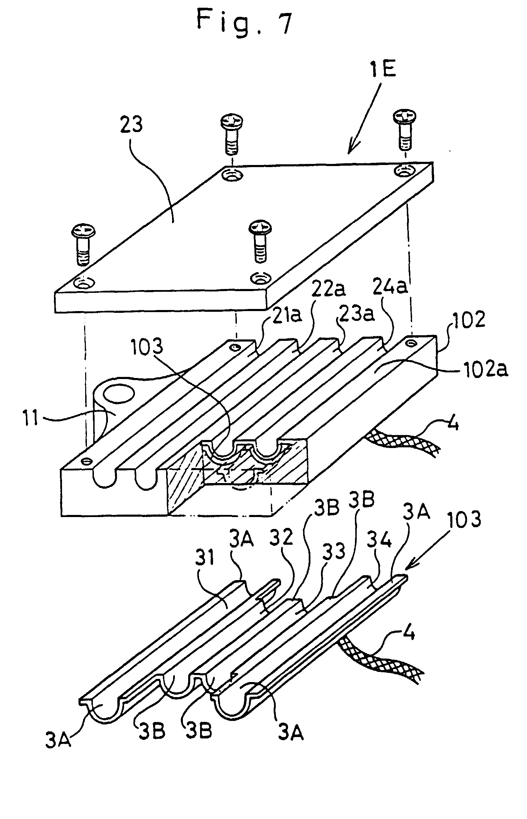

Fig. 7 shows a fourth non-embodiment of the invention, in which a spark plug voltage probe device 1E has a rectangular insulator base 102, upper surface 102a of which has grooves 21a ∼ 24a at regular intervals in a longitudinal direction. Along the grooves 21a ∼ 24a, an electrode plate 103 is embedded in the insulator base 102 to form a static capacitance between the electrode plate 103 and spark plug cables 41 ∼ 44 which are liquid-tightly placed in the corresponding grooves 21a ∼ 24a by way of an adhesive. The electrode plate 103 is in the form of corrugated configuration which has channels 31 ∼ 34 corresponding to the grooves 21a ∼ 24a of insulator base 102.

Among the channels 31 ∼ 34, longitudinal ends 3A, 3A of the outside channels 31, 34 extend beyond longitudinal ends 3B, 3B of the inside channels 32, 33 respectively. Thereby, each length of outside channels 31, 34 is greater than that of the inside channels 32, 33 so as to form substantially an H-shaped configuration as a whole.

This enables the device to compensate effectively for a capacitive shortage so that he static capacitance between the cables 41, 44 and the outside channels 31, 34 is substantially equal to the static capacitance between the cables 42, 43 and the inside channels 32, 33 thus making it possible to avoid differences among the static capacitances between each of the cables and the corresponding channels.

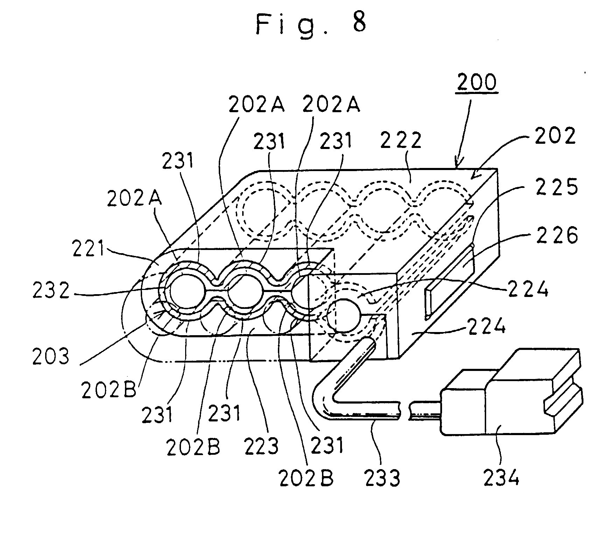

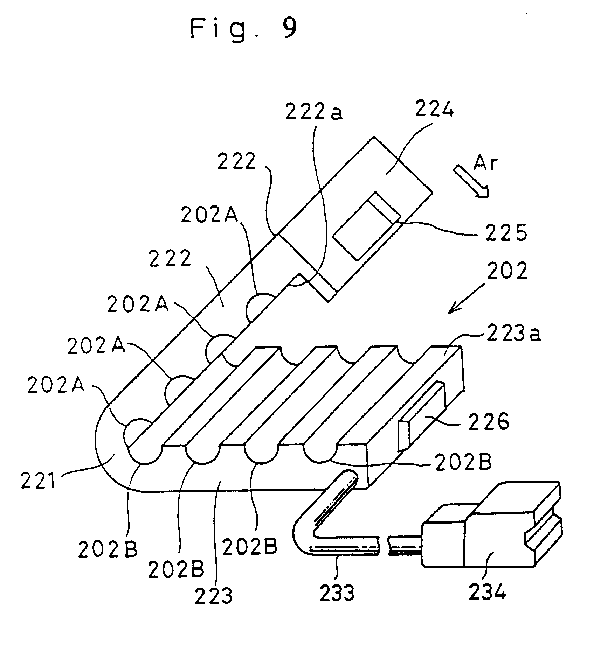

Referring to Figs. 8 and 9 which show a fifth non-embodiment of the invention, a spark plug voltage probe device 200 has an insulator base 202 including an upper half 222 and a lower half 223 which are integrally connected by a flexible portion 221. On a lower surface 222a of the upper half 222, grooves 202A are provided at regular intervals. On an upper surface 223a of the lower half 223, grooves 202B are provided which correspond to the grooves 202A. In the insulator base 202, an electrode plate 232 is embedded along the grooves 202A, 202B. The electrode plate 232 is in the form of a corrugated configuration which has channels 231 in correspondence to the grooves 202A, 202B. The electrode plate 232 is connected to a connector 234 by way of a lead wire 233.

From an open position in which the upper half 222 is away from the lower half 223, as shown in Fig. 9, the upper half 222 is folded around the flexible portion 221 in the direction of an arrow (Ar) to occupy a closed position in which the upper half 222 is snugly placed on the lower half 223 as shown in Fig. 8. One end of the upper half 222 integrally carries an elastic plate 224 having an opening 225 which admits a protrusion 226 provided on one end of the lower half 223 to latch the upper half 222 in the closed position.

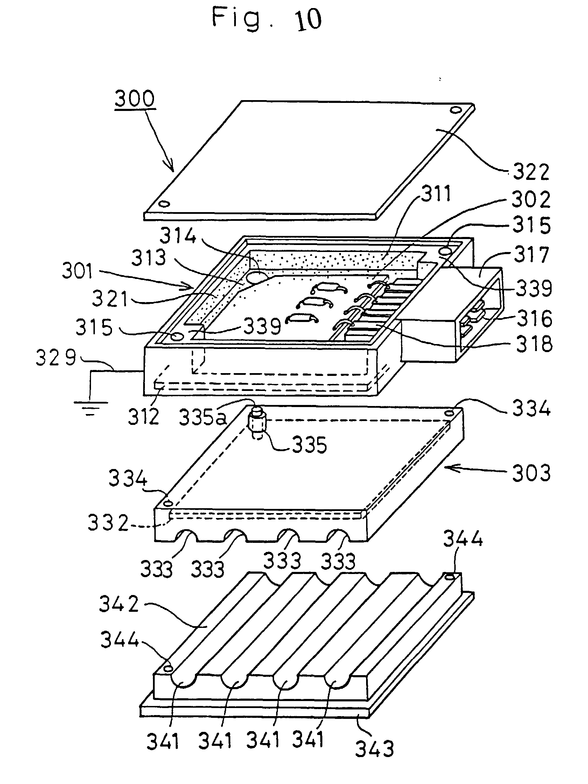

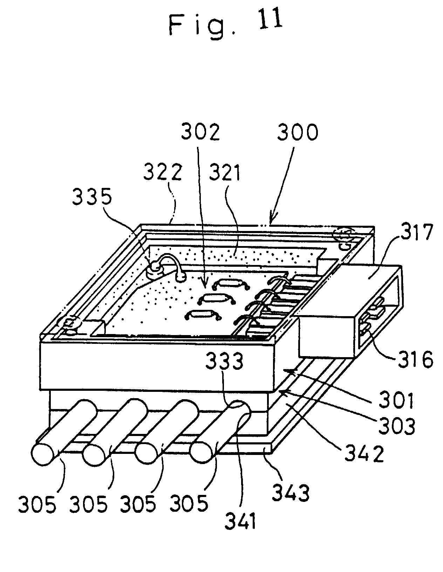

Referring to Figs. 10 and 11 which show a first embodiment of the invention, a sparkplug voltage probe device 300 has a rectangular casing 301 made of aluminum so as to act as an electrical shield means. By means of an electrically conductive wall 313, an inner space of the casing 301 is partitioned into an upper space and a lower space. The upper space of the casing 301 serves as an accommodation room 311, while the lower space of the casing 301 serves as a recess 312. The electrically conductive wall 313 has a hole 314 which permits a passage of a lead wire 335a which is connected to an electrode plate 332 as described hereinafter.

The casing 301 is grounded by way of the electrically conductive wall 313 and a ground wire 329. A set of orthogonally opposed corners 339 of the casing 301 has screw tightening holes 315. To one side of the casing 301, a connector 317 is integrally attached which has lead pins 316 each connected to terminals 318 within the casing 301. To the connector 317, a lead cable is connected with leads to a power source and an engine control device (now shown).

Within the accommodation room 311, an electrical circuit board 302 is placed, which is connected to the corresponding terminals 318. Then the accommodation room 311 is filled with a silicone rubber 321, and closed by an aluminum lid 322. Within the recess 312, an insulator base 303 is placed which is made of rubber, but may be made of synthetic resin. The insulator base 303 is secured to the casing 301 by tightening screws through holes 334. On a lower surface of the insulator base 303, grooves 333 are provided, the number of which corresponds to that of the cylinders of the internal combustion engine (E). In the insulator base 303, an electrode plate 332 is embedded along the grooves 333. The electrode plate 332 is connected to the electrical circuit board 302 by the lead wire 335a which is introduced into the accommodation room 311 by way of a guide pipe 335.

To a lower surface of the insulator base 303, a rubber plate 342 is fixedly secured by tightening appropriate screws through holes 344. On an upper surface of the rubber plate 342, grooves 341 are provided which correspond to the grooves 333. On a lower surface of the rubber plate 342, is an electrical shield sheet 343 which is attached by means of an adhesive so as to serve as a conductor wall.

Within each pair of the grooves 333, 341, a spark plug cable 305 is liquid-tightly placed to form a static capacitance between the electrode plate 332 and the cables 305 as shown in Fig. 11.

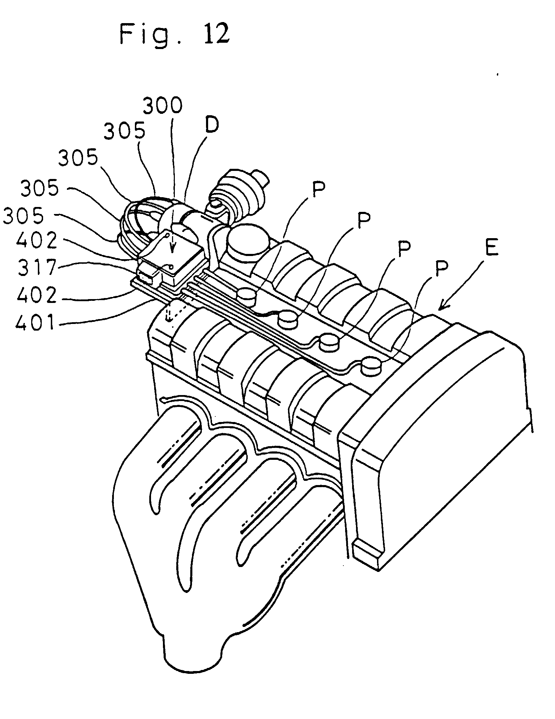

The sparkplug voltage probe device 300, thus assembled, is mounted on the internal combustion engine (E) by tightening bolts 402 to a bracket 401, and connecting the distributor (D) to the spark plugs (P) by way of the cables 305 as shown in Fig. 12.

According to the invention, the static capacitance (C2) is formed between the electrically conductive wall 313 and the electrode plate 332, and the static capacitance (C2) is greater than the static capacitance (C1) formed between the electrode plate 332 and the cables 305. Noise is reduced by the ratio of C1/C2 so as to prevent a signal (S) from being inadvertently disturbed when noise is caused from a capacitive discharge component of the sparkplug voltage system.

The circuit board 302 is accommodated in the electrical shield casing 301 so that the circuit board 302 is protected against disturbance of electromagnetic waves due to the ignition system.

Since the electrode plate 332 is protected by the electrically conductive wall 313 and the electrical shield sheet 343, the electrode plate 332 is hardly affected by the electromagnetic noise (N) due to the peripheral parts of the internal combustion engine (E), thus reducing the ratio of N/S to detect the burning conditions in the internal combustion engine (E) precisely.

It is noted that the casing 301 may be made of synthetic resin, an inner side wall of which is coated with a metallic layer, otherwise the casing 301 may be made of synthetic resin in which a metallic sheet is embedded.

It is also noted that the electrode plate 332 may be corrugated sheet which has channels corresponding to the grooves 333.

It is appreciated that the electrical shield sheet 343 may be made integrally with the bracket 401.

## Claims

1. A sparkplug voltage probe device (300) for attachment to an internal combustion engine (E) and for detecting a voltage applied to spark plugs (P) installed in the internal combustion engine by way of corresponding cables (305), the device comprising:
an insulator base (303);
a plurality of grooves (333) in which the corresponding cables are to be placed; and
an electrode layer (332) embedded in the insulator base along the grooves for forming a static capacitance between the electrode layer and placed cables when the voltage is supplied across the spark plugs; characterised by further comprising
an electrical shield casing (301) in which at least one electrical circuit board (302) is accommodated, the shield casing having an electrically conductive wall (313) electrically grounded in use;
a lead wire (335a) connecting the electrode layer (332) to said at least one electrical circuit board (302)
a rubber plate (342) securely attached to a lower surface of the insulator base; and
an electrical shield sheet (343) fixedly attached to a lower surface of the rubber plate; and in that
the insulator base is securely attached to the outer surface of the base of the electrical shield casing, and the electrode layer is electrically connected to the at least one electrical circuit board so as to analyse a burning condition in the internal combustion engine on the basis of the voltage applied to each of the spark plugs; and
the plurality of grooves is provided between the insulator base and the rubber plate (342), in use the noise level being reduced by the ratio of the static capacitance C1 which is formed between the electrode layer and the cables to a static capacitance C2 which is formed between the electrically conductive wall and the electrode layer.

2. A device as recited in claim 1, further comprising a second electrical shield layer embedded in the insulator base in the proximity of the electrode layer on the side of the electrode layer remote from the grooves, so as to shield the electrode layer electrically.

3. A device according to claim 1 or 2, wherein the electrode layer is provided with two side portions extending in the direction of said grooves, of greater length than its central portion, to form substantially an H-shaped configuration in plan view, whereby the static capacitance between the electrode layer and the cables has an even distribution.

4. A device according to claim 1, 2 or 3, wherein said insulator base (303) and said rubber plate (342) are integrally connected by means of a pivot portion, both said insulator base and said rubber plate providing said grooves for holding said corresponding cables when the two parts are closed together;
and wherein said electrode layer is also embedded in said rubber plate.

5. A device according to any one of the preceding claims, wherein said electrode layer is corrugated in section.

6. An internal combustion engine (E) having a device as defined in any one of the preceding claims securely attached thereto by means of a mounting bracket (401).

## Patentansprüche

1. Zündkerzenspannungsmessfühler (300) zur Anbringung an einem Verbrennungsmotor (E) mit innerer Verbrennung und Erfassung einer Spannung, die an in den Verbrennungsmotor eingesetzte Zündkerzen (P) über entsprechende Kabel (305) angelegt wird, wobei der Messfühler aufweist:
einen Isoliersockel (303);
mehrere Rillen (333), in denen die entsprechenden Kabel zu liegen kommen; und
eine Elektrodenlage (332), die in dem Isoliersockel entlang den Rillen eingebettet ist, um eine statische Kapazität zwischen der Elektrodenlage und den eingelegten Kabeln zu bilden, wenn die Spannung an die Zündkerzen geliefert wird; dadurch gekennzeichnet, dass der Messfühler weiterhin aufweist
ein elektrisches Abschirmgehäuse (301), in dem wenigstens eine elektrische Schaltungsplatte (302) untergebracht ist und das elektrisch leitende Wände (313) hat, die im Gebrauch elektrisch geerdet sind;
einen Leitungsdraht (335a), der die Elektrodenlage (332) mit der wenigstens einen elektrischen Schaltungsplatte (302) verbindet,
eine Gummiplatte (342), die sicher an einer unteren Oberfläche des Isoliersockels angebracht ist; und
ein elektrisches Abschirmblatt (342), das fest an der unteren Oberfläche der Gummiplatte angebracht ist, und dass
der Isoliersockel an der Außenoberfläche der Basis des elektrischen Abschirmgehäuses angebracht ist, und die Elektrodenlage elektrisch mit der wenigstens einen elektrischen Schaltungsplatte derart verbunden ist, dass eine Verbrennungssituation in dem Verbrennungsmotor auf der Basis der jeder der Zündkerzen angelegten Spannung analysiert wird, und
die mehreren Rillen zwischen dem Isoliersockel und der Gummiplatte (342) vorgesehen sind, wobei im Gebrauch der Störpegel durch das Verhältnis der statischen Kapazität C1, die zwischen der Elektrodenlage und den Kabeln gebildet ist, zu einer statischen Kapazität C2 verringert wird, die zwischen der elektrisch leitenden Wand und der Elektrodenlage gebildet ist.

2. Zündkerzenspannungsmessfühler nach Anspruch 1, der weiterhin eine zweite elektrische Abschirmlage aufweist, die in den Isoliersockel in der Nähe der Elektrodenlage auf der Seite der von den Rillen entfernt liegenden Elektrodenlage so eingebettet ist, dass sie die Elektrodenlage elektrisch abschirmt.

3. Zündkerzenspannungsmessfühler nach Anspruch 1 oder 2, bei dem die Elektrodenlage mit zwei sich in Richtung der Rillen erstreckenden Seitenabschnitten versehen ist, deren Länge größer ist als ihr Mittelabschnitt, und so in ebener Ansicht eine im wesentlichen H-förmige Gestalt hat, wodurch die statische Kapazität zwischen der Elektrodenlage und den Kabeln gleichförmig verteilt ist.

4. Zündkerzenspannungsmessfühler nach Anspruch 1, 2 oder 3, bei dem der Isoliersockel (303) und die Gummiplatte (342) einstückig durch ein Scharnierteil verbunden sind und der Isoliersockel als auch die Gummiplatte die Rillen zum Halten der entsprechenden Kabel bilden, wenn die beiden Teile geschlossen sind, und bei dem die Elektrodenlage ebenfalls in die Gummiplatte eingebettet ist.

5. Zündkerzenspannungsmessfühler nach einem der vorangehenden Ansprüche, bei dem die Elektrodenlage abschnittsweise gewellt ist.

6. Verbrennungsmotor (E) mit innerer Verbrennung, der einen in den vorangehenden Ansprüchen definierten Zündkerzenspannungsmessfühler hat, der mittels einer Befestigungsklausekkonsole (401) am Motor befestigt ist.

## Revendications

1. Dispositif testeur de potentiel de bougie d'allumage (300) destiné à être fixé à un moteur à combustion interne (E) et à détecter une tension appliquée à des bougies d'allumage (P) installées dans le moteur à combustion interne au moyen de câbles correspondants (305), le dispositif comprenant :
une base isolante (303) ;
une pluralité de gorges (333) dans lesquelles les câbles correspondants doivent être placés ; et
une couche d'électrode (332) noyée dans la base isolante le long des gorges pour former une capacité statique entre la couche d'électrode et les câbles mis en place lorsque la tension est appliquée aux bougies d'allumage ; caractérisé en ce qu'il comprend en outre
un boîtier de blindage électrique (301) dans lequel est reçue au moins une carte à circuits imprimés (302), le boîtier de blindage ayant une paroi électriquement conductrice (313) mise électriquement à la masse en utilisation ;
un fil conducteur (335a) reliant la couche d'électrodes (332) à la ou auxdites carte(s) à circuits imprimés (302)
une plaque de caoutchouc (342) liée de manière fixe à une surface inférieure de la base isolante ;
une feuille de blindage électrique (343) liée de manière fixe à une surface inférieure de la plaque de caoutchouc ;
et en ce que la base isolante est liée de manière fixe à la surface extérieure de la base du boîtier de blindage électrique, et la couche d'électrode est reliée électriquement à la ou aux carte(s) à circuits imprimés de manière à analyser une condition de combustion dans le moteur à combustion interne sur la base de la tension appliquée à chacune des bougies d'allumage ; et
la pluralité de gorges est réalisée entre la base isolante et la plaque de caoutchouc (342), le niveau de bruit étant réduit en utilisation par le rapport de la capacité statique C1 formée entre la couche d'électrode et les câbles et une capacité statique C2 formée entre la paroi électriquement conductrice et la couche d'électrode.

2. Dispositif selon la revendication 1, comprenant en outre une seconde couche de blindage électrique noyée dans la base isolante à proximité de la couche d'électrode sur le côté de la couche d'électrode éloignée des gorges de façon à réaliser un blindage électrique de la couche d'électrode.

3. Dispositif selon la revendication 1 ou 2, dans lequel la couche d'électrode est réalisée avec deux portions latérales s'étendant dans la direction desdites gorges, de plus grande longueur que sa partie centrale, pour former sensiblement une configuration en forme de H en vue en plan, la capacité statique entre la couche d'électrode et les câbles ayant une distribution régulière.

4. Dispositif selon la revendication 1, 2 ou 3, dans lequel ladite base isolante (303) et ladite plaque de caoutchouc (342) sont reliées d'un seul tenant au moyen d'une portion de pivot, ladite base isolante et ladite plaque de caoutchouc réalisant toutes deux lesdites gorges pour retenir lesdits câbles correspondants lorsque les deux parties sont fermées mutuellement ;
et dans lequel ladite couche d'électrode est également noyée dans ladite plaque de caoutchouc.

5. Dispositif selon l'une quelconque des revendications précédentes, dans lequel ladite couche d'électrode est cannelée en section.

6. Moteur à combustion interne (E) comportant un dispositif selon l'une quelconque des revendications précédentes lié de manière fixe à lui au moyen d'un support de montage (401).
